# EUROPEAN PATENT APPLICATION

(11) **EP 4 560 401 A1**
(43) Date of publication of application: **28.05.2025**
(21) Application number: 23212376.0
(22) Date of filing: 27.11.2023
(51) Int. Cl.: G03F 7/20

(54) **ASSEMBLY FOR WAVELENGTH CALIBRATION**

(71) Applicant: ASML Netherlands B.V., 5500 AH Veldhoven (NL)
(72) Inventor: CRAMER, Hugo Augustinus Joseph, 5500 AH Veldhoven (NL)
(74) Representative: ASML Netherlands B.V.

(57) **Abstract**

An assembly for calibrating a radiation wavelength. The assembly can be provided in a metrology apparatus. The assembly comprises an input configured to receive radiation. The assembly further comprises a diffracting element for diffracting radiation. The diffracting element comprises a bottom layer having a lateral periodic structure for diffracting radiation at an upper surface of the bottom layer, and a top layer having a lower surface that is adjacent to the periodic structure and wherein the top layer has a top surface that is flat. The diffracting element is arranged to receive the radiation on the upper surface of the top layer, and to reflectively diffract the radiation such that the radiation exits the diffracting element via the upper surface of the top layer. The assembly further comprises a detector configured to detect the diffracted radiation.

## Description

### FIELD

The present invention relates to an assembly for calibrating a radiation wavelength. In particular it relates to an assembly with a diffracting element comprising a bottom layer with a diffracting structure and a top layer with a flat surface through which the radiation enters and exist the diffracting element.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating/target medium, thereby generating an emitted radiation, optionally a high harmonic generation (HHG) comprising high frequency radiation.

One method of measuring a patterned structure on a substrate uses diffraction-based metrology. Diffraction-based metrology can be performed by irradiating a target diffractive structure (e.g. a grating) on a substrate and capturing the diffracted radiation beam. The captured diffracted radiation can be analyzed to infer parameters of interest. In order for the inference of parameters to work, the characteristics of the radiation beam and the target structure should be known. Knowing the diffractive properties of a diffractive structure can either be done through modelling or by calibration. Modelling requires full knowledge of the target geometry of the diffractive structure. Calibration requires that the grating remained stable over time. As changes over time may occur, modelling or calibration may need to be repeated periodically to take such changes into account. Modelling the diffractive structure may require detailed knowledge of the exact properties of the grating, which may be difficult to achieve accurately in practice.

The metrology setup may be present in a vacuum chamber. It is a well-known problem that contaminants may be deposited on the surfaces of elements present in a vacuum chamber over time. This may lead to a thin coating of contaminants being present on the surfaces of elements inside the chamber, and as a result the performance of these elements may be reduced. It may affect the stability and efficiency of the elements, and lead to reduced performance of the metrology apparatus. Implementations described herein may provide a solution to the challenge of contaminants reducing performance of diffractive elements.

### SUMMARY

According to an aspect of the current disclosure there is provided an assembly for calibrating a radiation wavelength. The assembly comprises an input configured to receive radiation. The assembly further comprises a diffracting element for diffracting radiation. The diffracting element comprises a bottom layer having a lateral periodic structure for diffracting radiation at an upper surface of the bottom layer, and a top layer having a lower surface that is adjacent to the periodic structure and an upper surface that is flat. The diffracting element is arranged to receive the radiation on the upper surface of the top layer, and to reflectively diffract the radiation such that the radiation exits the diffracting element via the upper surface of the top layer. The assembly further comprises a detector configured to detect the diffracted radiation.

Optionally, the top layer may have a height extending beyond a height of the lateral periodic structure.

Optionally the top layer may have a height that is in line with a height of the lateral periodic structure.

Optionally, the detector may contain a spatially resolved sensor.

Optionally, the radiation may comprise a plurality of wavelengths in a range from 1 nm to 20 nm, in a range from 1 nm to 10 nm, in a range from 10 nm to 20 nm, in a range from 9 nm to 18 nm.

Optionally, the periodic structure may comprise a periodic grating.

Optionally, the bottom layer may comprise a first material and the top layer may comprise a second material, wherein the first material and the second material may have a different refractive index for wavelengths of the radiation.

Optionally, the second material may comprise at least one of an oxide, or a nitride, or a carbon-based material.

Optionally, the periodic structure may have a height difference in a direction perpendicular to the flat surface of the top layer in a range of 1 nm to 10 nm, or in a range of 1 nm to 7.5 nm.

Optionally, the top layer has a thickness of at least 1 nm, or of at least 2 nm.

Optionally, the periodic structure may have a pitch in a range from 1 nm to 100 nm.

Optionally, two or more different periodic structures may be combined in the diffractive element.

Optionally, the diffracting element may be provided on a substrate support.

Optionally, the diffracting element may be provided on a component of an illumination system.

Optionally, the component of the illumination system may be a toroidal mirror.

According to another aspect of the current disclosure there is provided a metrology apparatus comprising an assembly as described above.

According to another aspect of the current disclosure there is provided an inspection tool comprising an assembly as described above.

According to another aspect of the current disclosure there is provided a lithographic apparatus comprising an assembly as described above.

According to another aspect of the current disclosure there is provided a litho cell comprising an apparatus as described above.

According to another aspect of the current disclosure there is provided a reflective mirror comprising an assembly as described above. Optionally, the reflective mirror comprises a curved reflective surface. Optionally the reflective mirror is a toroidal mirror.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a schematic representation of an assembly for calibrating a radiation wavelength;
- Figures 9(a) and 9(b) depict schematic representations of the diffracting element;
- Figure 10(a) depicts an example chart of diffraction efficiency as a function of wavelength for different diffracting element configurations; and
- Figure 10(b) depicts an example chart of change in relative diffraction efficiency for exposed and buried gratings.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

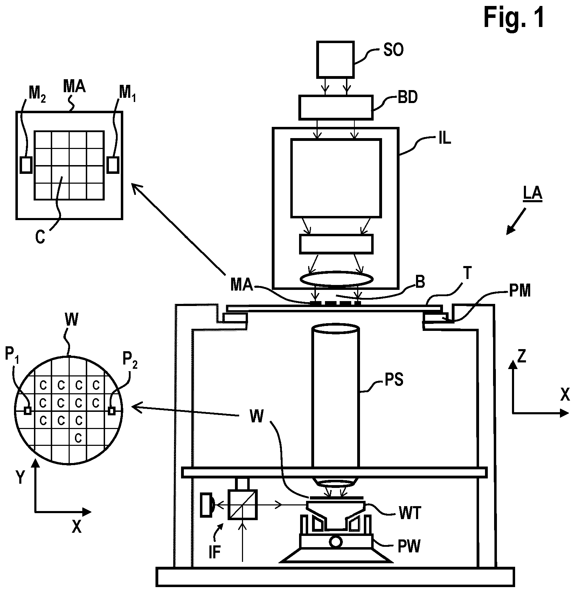

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

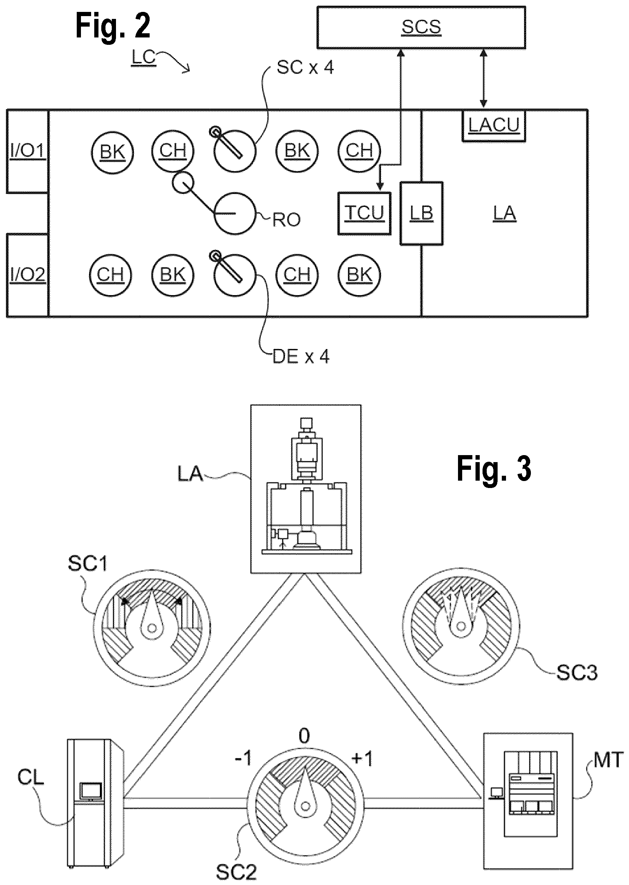

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

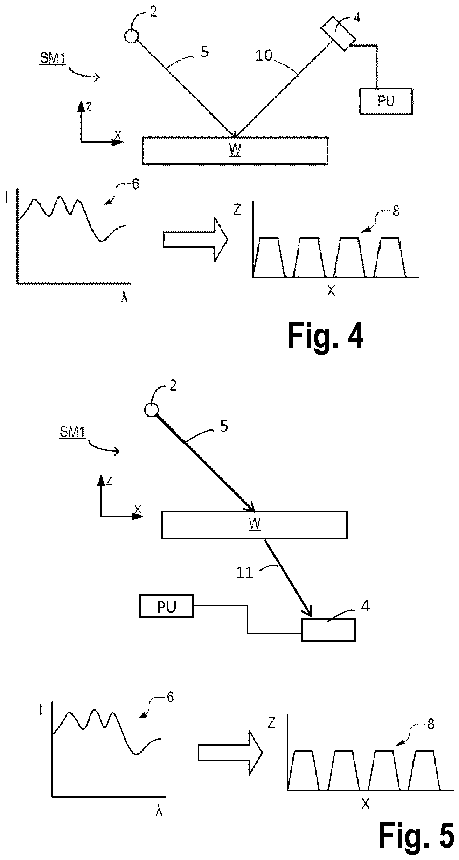

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1 nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

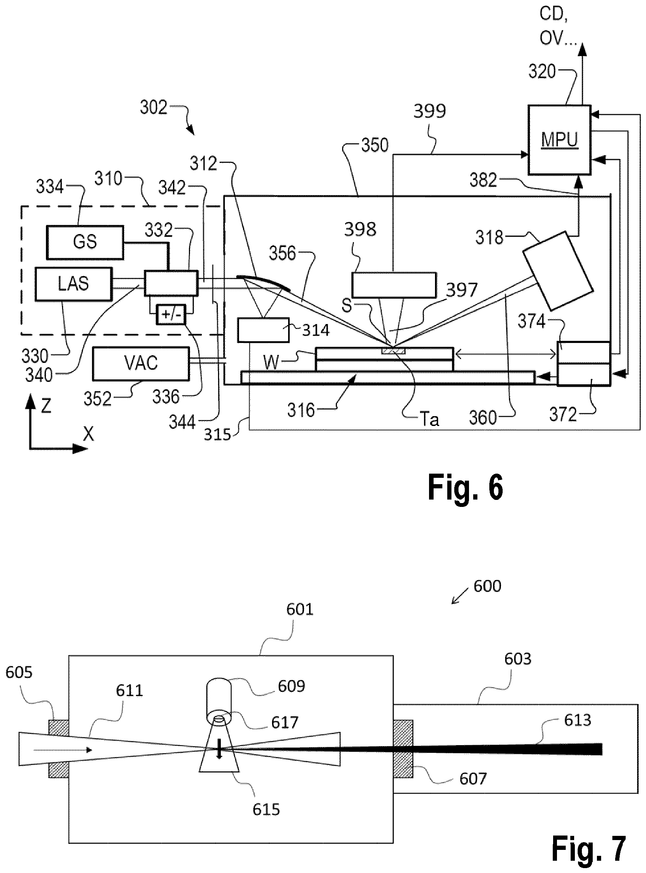

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source, as well as other types of sources, may have a gas target and be a gas jet/nozzle source, a capillary/fiber source or a gas cell source. The HHG source, as well as other types of sources, may have a solid or liquid target. Although HHG source with gas target is described in the text below, it will be appreciated that the invention is not limited to HHG source with gas target and may be used in HHG source with solid or liquid target and other types of source with any target. The gas target, solid target and liquid target may be referred as generating/target medium.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus.The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use HHG or any other types of sources mentioned above to obtain radiation at the desired wavelength(s).

Figure 7 shows a simplified schematic drawing of an embodiment 600 of an illumination source 310, which may be the illumination source for HHG. One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

A challenge in lithography applications may present itself where calibration of sensors and detectors may be difficult due to the small scales of the structures and/or the short wavelengths of the radiation used in the setups. Due to the material interaction properties of short wavelengths, the type of components available to control the radiation may be limited. Metrology apparatus may use short wavelength radiation comprising a plurality of different wavelengths. In order to determine properties in a metrology setup, diffraction may be used to directionally separate different wavelengths. This directional wavelength-based separation may result in spatial separation in the far field. This may be used to calibrate for example one or more wavelengths of the radiation, or a wavelength-sensitive detector. A diffracting element used to spectrally split radiation into different wavelength components may be referred to as a spectrally dispersive element, which may for example comprise a diffraction grating.

Diffraction-based metrology may be an important metrology method, for example for overlay and/or profile metrology. A promising variant of diffraction-based metrology may use narrow beam short wavelength radiation to irradiate a target diffraction structure. The diffracted radiation orders may be captured by a detector. In order to translate the diffracting signal in reflection, and to infer parameters of interest, a spectral intensity of the radiation beam may be calibrated. If the radiation beam is calibrated and its properties are known, the effects of the radiation properties and the irradiated structure may be separated in analysis of measurement radiation signals. The calibration of the radiation may be monitored over time, to identify any changes to the calibration setup. Changes to the calibration setup may for example occur as a result of contaminants affecting the performance of the calibration setup.

Determining the spectrum and intensity of the radiation for calibration may in some implementations be achieved by separating a portion of the measurement radiation beam into a separate branch. The separate branch may be referred to as a reference branch. In other example implementations a spectrally resolved detector may be placed along the radiation path. In both options a diffraction grating may be used to achieve a spectral decomposition of the radiation. In another example implementation a diffraction grating may be placed on a substrate support, in which case the same detector that is used to capture the substrate signal may be used to calibrate the radiation beam.

High-resolution, short-wavelength measurements are often performed in a vacuum. This may for example be to protect the target structure and/or metrology components. However, even under vacuum conditions, contaminants may be present in the environment. These contaminants may be deposited on surfaces inside the metrology setup, especially in areas where the radiation intensity is high, such as areas of components where radiation is incident. This may include for example a diffracting structure to be used for wavelength calibration. A challenge associated with this is that the presence of the contaminants may affect the properties of the diffracting structure. Therefore, in a vacuum chamber, the properties of a diffracting structure may change over time, meaning the accuracy of the calibration is reduced over time. In order to re-calibrate, knowledge of the new diffracting properties of the contaminated structure would be required, either through modelling or recalibration. Modelling may require full knowledge of the target geometry and composition. Calibration may require that the grating remained stable. Obtaining the modelling information is not straightforward, meaning that contamination of a diffracting structure can negatively affect performance and accuracy of the metrology setup.

Contaminants inside a vacuum chamber may comprise carbon or carbon-containing material. Optical elements in the vacuum chamber may be contaminated with a thin layer of carbon or carbon - containing material, which may for example be deposited under the influence of the short wavelength radiation. The amount of carbon contaminants deposition may increase over time. This may affect the stability of the diffraction efficiency of the diffracting element. While it may be possible to model the deposited contaminant layer, this would require detailed knowledge of the growth mechanism, for example whether it is a conformal deposition process. It may also require details regarding deposition around corners of the diffracting structure. Provided herein are assemblies to address challenges relating to contaminant deposition on diffracting structures.

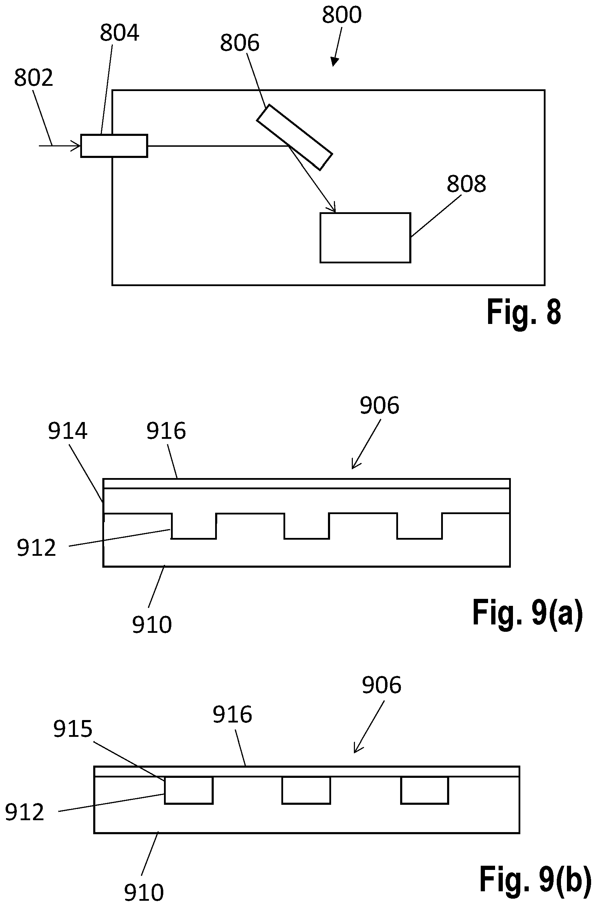

Figure 8 depicts a schematic representation of an assembly 800 for calibrating a radiation wavelength. The assembly may be provided in a metrology apparatus. The assembly comprises an input 804 configured to receive radiation 802. Optionally the radiation 802 is one embodiment of the emitted radiation 342. Optionally the radiation 802 is one embodiment of the focused beam 356. Optionally the radiation 802 is one embodiment of the reflected radiation 360. The assembly comprises a diffracting element 806 for diffracting radiation. The diffracting element comprises a bottom layer having a lateral periodic structure for diffracting radiation at an upper surface of the bottom layer. The diffracting element further comprises a top layer having a lower surface that is adjacent to the periodic structure of the bottom layer, and an upper surface that is flat. The lateral periodic structure in a bottom layer covered by a top layer may be referred to as a buried lateral periodic structure. The diffracting element is arranged to receive radiation on the upper surface of the top layer. The diffracting element reflectively diffract the radiation such that the radiation experts the diffracting element via the upper surface of the top layer. The assembly further comprises a detector 808 configured to detect at least some of the diffracted radiation.

An advantage of an assembly as described in relation to figure 8 may be that any contaminants are deposited on a flat surface and therefore have a significantly reduced / substantially insignificant effect on the diffractive properties of the diffracting element. Diffraction in the short wavelength domain may be dominated by single scattering. Therefore, diffraction at short wavelengths may be mostly sensitive to changes in the patterned layers of the lateral periodic structure. In the described assembly the periodic structure is buried under a layer of other material. The upper layer of this material is flat, for example by depositing a planarising material on top of the periodic structure. If a contaminant layer is deposited on a diffractive element with a planarised top layer, it may form a uniform, unpatterned layer on top of the top layer material. As a result, the diffraction of the radiation by the periodic structure is not affected by the deposition of the uniform, planar contamination layer. The contamination layer may only significantly affect second order reflections of the scattered light on the interfaces of the contamination layer. This second order reflection may have a small impact on the overall diffraction efficiency.

Figure 9(a) depicts a schematic representation of a first implementation of a diffracting element 906 as described in relation to figure 8. The diffracting element 906 comprises a bottom layer 910. A lateral periodic structure 912 may be present on an upper surface of the bottom layer 910. The lateral periodic structure may comprise a grating. The diffracting element 906 may comprise a top layer 914, wherein the top layer may be adjacent to the upper surface of the bottom layer 910. The top surface of the top layer may be flat. A flat surface may also be referred to as a planar surface, which may be understood to be a two-dimensional surface. A layer of contaminants 916 may be deposited on top of the top surface when the diffracting element is in use in the metrology apparatus. The layer of contaminants 916 is optional.

Figure 9(b) depicts a schematic representation of a second implementation of the diffracting element 906 as described in relation to figure 8. The diffracting element 906 comprises a bottom layer 910. A lateral periodic structure 912 may be present on an upper surface of the bottom layer 910. The lateral periodic structure may comprise a grating. The diffracting element 906 may comprise a top layer 915, wherein the top layer 915 may be adjacent to the upper surface of bottom layer 910. The top layer may be used to fill in gaps in the lateral periodic structure 912, such that the height of the top layer is the same as the height of the lateral periodic structure. An upper surface of the top layer may reach to the same height as the height of the lateral periodic structure of the bottom layer. The resulting upper surface of the diffracting element 906 may be flat/planar, formed from a combination of upper surface of the top layer and upper surface of the bottom layer. The resulting diffracting element may therefore have a height that is in line with a height of the lateral periodic structure, to form a planar surface. While a top layer is described as a single layer, in some instances it is possible for the top layer to be formed from a plurality of disconnected portions of material.

For some embodiments, the embodiment of Figure 9(a) is preferred than that of Figure 9(b), due to manufacturing reasons. The manufacturing may be easier when the top surface consists of one material. It may be difficult to flatten/planarize a patterned layer or a surface with more than one materials, because of different chemical mechanical polishing (CMP) rates of different materials

The bottom layer 910 of the diffracting element 906 may comprise a first material. The first material may for example comprise poly-silicon, amorphous silicon. The first material may for example comprise metal, metal oxide, silicon, silicon dioxide, and/or silicon nitride. The top layer may comprise a second material. Optionally the first material and the second material may have a different refractive indices. Specifically, the refractive index of the first and second materials may be different for wavelengths of the radiation interacting with the diffracting element (e.g. in the range of 1 nm to 20 nm). The second material may comprise at least one of an oxide, a nitride, or a carbon-based material. The carbon-based material may have planarising properties that assist in the top surface being flat, such as for example spin-on-carbon. The second material may be selected to have as much optical contrast as possible with the first material. The second material may further be selected so that it is compatible with semiconductor processes.

The radiation 802 may comprise a plurality of wavelengths. The radiation may comprise a plurality of wavelengths in a range from 1 nm to 20 nm, in a range from 1 nm to 10 nm, or in a range from 10 nm to 20 nm, or in a range from 9 nm to 18 nm. Calibrating the radiation 802 may be understood to comprise calibrating a spectrum of the radiation. Calibrating radiation 802 may comprise determining a wavelength and/or intensity of captured radiation. The radiation to be calibrated ay comprise a spatially resolved sensor. The spatially resolved sensor may be a spectrometer. The diffracting structure 806 may diffract different wavelengths in different directions. The wavelengths travelling in different directions may be captured at different positions on the spatially resolved sensor, thereby resolving the wavelengths. The spatially resolved sensor may for example be a CCD (Charged Coupled Device) array or a CMOS (Complementary Metal-Oxide-Semiconductor) sensor.

An advantage of using the spatially resolved sensor with a diffracting structure may be that it enables calibration of short-wavelength radiation, as in the wavelength ranges described above. For radiation in and/or near the visible wavelength range, more optical components are available, which may be used for calibration. Optical components that work in transmission, such as for example prisms, may be used to spectrally separate radiation in the visible part of the spectrum. However, at sorter wavelengths, absorption of radiation by materials is significantly higher, making prisms and other components unavailable or challenging to produce. A diffracting element as described herein may operate in reflection.

The layers of the diffracting element may be planar layers, and the lateral periodic structure may comprise a periodically repeating structure in a direction which is perpendicular to the plane of the layers. The lateral periodic structure may comprise a feature that is non-parallel to the direction of propagation of incident radiation. The periodic structure may have a height differential in the direction lateral to the plane of the layer. The height difference may be at least 1 nm. The requirements on the height of a structure may be wavelength-dependent. The height may be shorter than half of the longest wavelength in the radiation to be calibrated, or preferably shorter than a third of the shortest wavelength to be calibrated. If the height of the periodic structure is too low, the diffracting effect will be too small. If the height of the periodic structure is too tall, interference effects may occur. The height may be set in a range between these two effects occurring. For example, the lateral periodic structure may comprise a height difference in a range of 1 nm to 10 nm, or in a range of 1 nm to 7.5 nm. The top layer may have a thickness of at least 1 nm, or of at least 2 nm. Is described in relation to Figure 9(b), in some instances the top layer may have a thickness of 0 nm in some areas above parts of the lateral periodic structure that protrude from the base of the bottom layer. This may be such that the height of the top layer may be level with the highest parts of the lateral periodic structure of the bottom layer.

The lateral periodic structure may comprise a periodic grating. Optionally the periodic grating has a periodicity in one direction. Optionally the periodic grating has a periodicity in two perpendicular directions. The periodic structure may have a pitch in a range from 1 nm to 100 nm, or in a range from 30 nm to 300 nm. The minimum pitch maybe half of the shortest wavelength to be diffracted, or preferably at least half of the longest wavelength to be diffracted.

The periodic structure may comprise a plurality of periodic structures. In a first implementation, a plurality of periodic structures may comprise a plurality of gratings with different pitches. The plurality of gratings may be present on the same portion of a substrate. These multiple periodic structures with different pitches may have similar lateral heights. In some implementations the plurality of the periodic structures may comprise multiple structures from different substrates. The different structures may have different layer heights, and optionally different pitches.

The diffracting element may be provided on a substrate support present in the metrology apparatus. The substrate support may be configured to hold a substrate to be measured. Therefore, the diffracting element may be adjacent to the substrate to be measured by the metrology apparatus. Alternatively or additionally, a diffracting element may be provided on a component of an illumination system of the metrology apparatus. The component of the illumination system may for example be a reflective mirror, optionally a reflective mirror with a curved reflective surface, and optionally a toroidal mirror.

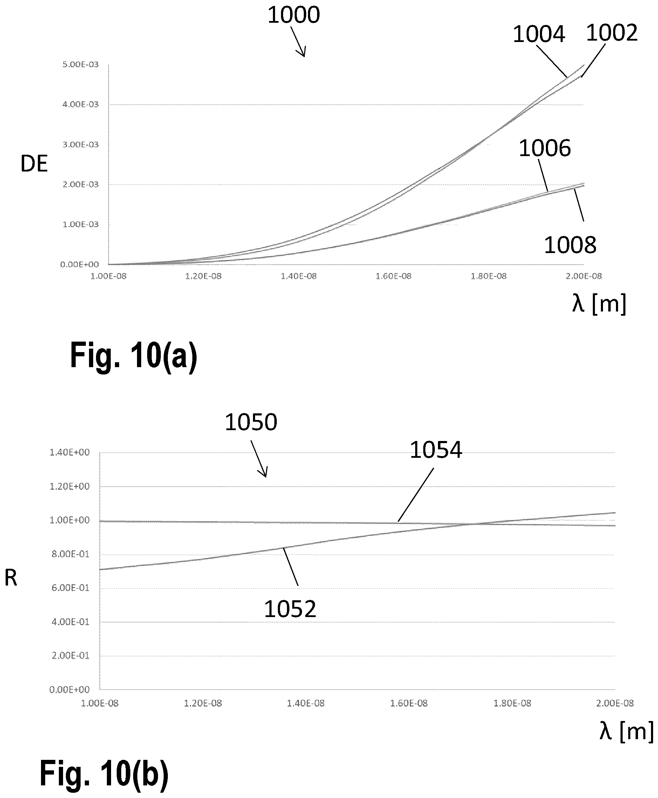

Figure 10(a) depicts an example chart 1000 of change in diffraction efficiency DE as a function of wavelength λ. Graphs 1002 and 1004 depict diffraction efficiency for an 'exposed' grating that is not buried under a planar top layer. Graph 1002 shows a grating that has no carbon deposition, and graph 1004 shows a grating with a 1 nm carbon deposition layer on top of the grating. The graphs show a clearly observable impact of a 1 nm carbon deposition layer on the diffraction efficiency of the exposed, non-buried gratings. Graphs 1006 and 1008 depict diffraction efficiency for a grating buried under a top layer, as described in relation to figure 9(a) and 9(b). Graph 1006 shows a grating that has no carbon deposition, and graph 1008 shows a grating with a 1 nm carbon deposition layer on top of the grating. The graphs show a significantly reduced impact of the 1nm carbon deposition layer on the diffraction efficiency of the buried gratings.

Figure 10(b) depicts an example chart 1050 depicting a relative change in diffraction efficiency R as a function of wavelength. The change may be between a grating without carbon deposition, and a grating with a 1 nm carbon layer deposition. Graph 1052 depicts an example relative change for an exposed, non-buried grating. The relative change in diffraction efficiency goes up to 30% for the exposed grating. Graph 1054 depicts an example relative change for a buried grating. The highest relative change in diffraction efficiency that is observed is reduced to 3.3%. This may equate to an improvement in performance of the buried grating of around 9 times, compared to an exposed grating.

The charts of figures 10(a) and 10(b) illustrate that the detrimental effects of contaminant deposition on diffracting structures may be significantly reduced by burying the structure under a planar layer. This may have an advantage of increasing the lifetime of the diffracting element, as it is able to tolerate a larger amount of contaminant deposition while remaining functional

While the above buried gratings and diffracting elements are described for applications in reflection, an alternative implementation that functions in transmission may also be provided. In order to achieve this, a different type of diffracting element that functions in transmission may be provided in the assembly. A diffractive element comprising a periodic structure for diffracting radiation may be provided. The diffractive element may function in transmission and may comprise a metal layer. The periodic structure may be etched into the metal layer. Wherein the etching has removed all the metal material, and the resulting etched areas comprise open are reaching through the entire metal layer. The periodic structure may comprise a periodic grating, which may be a periodic transmissive grating. The periodic structure may receive radiation at a first side of the metal layer. A portion of the received radiation may be transmitted through the metal layer and may be diffracted on a second side of the metal layer, opposite the first side of the metal layer. The radiation may be short-wavelength radiation as described above.

One embodiment is a diffracting element functioning in transmission, which may be referred as a transmissive diffracting element. The transmissive diffracting element may comprise a lateral periodic structure with a top interface and a bottom interface. The transmissive diffracting element may have the same features as the periodic structure 912 described in relation to Figure 9(a)-(b), unless where those features specifically relate to reflection and are incompatible in transmission. The transmissive diffracting element may comprise a capping layer, optionally with the same features as the top layer 914 in Figure 9(b). In one embodiment, the capping layer caps both the top interface and the bottom interface of the lateral periodic structure and has two surfaces, i.e. the top surface and the bottom surface. The surface of the capping layer may be flat, as mentioned in the embodiment 906 in Figure 9. The layer of contaminants 916, as shown in Figure 9, may be deposited on one or two surfaces of the capping layer. Optionally spaces between the lateral periodic structures are filled by material of the capping layer.

In one further embodiment, the capping layer caps the top interface of the lateral periodic structure while the bottom interface of the lateral periodic structure is not capped but planarized by the material of the capping layer. The further embodiment may have two different surfaces: surface of the capping layer and surface of the planarized interface. The surface of the planarized interface may comprise both the material of the capping layer and the material of the lateral periodic structure. Optionally the layer of contaminants 916 is deposited on both the surface of the capping layer and the surface of the planarized interface. Optionally the layer of contaminants 916 is deposited on the surface of the capping layer but not on surface of the planarized interface. Optionally the layer of contaminants 916 is deposited on the surface of the planarized interface but not on the surface of the capping layer.

For the embodiments comprising the transmissive diffracting element, the capping layer prevents deposition on the transmissive diffracting element, especially on the sidewall of the lateral periodic structure, which may affect the stability of the diffraction efficiency of the transmissive diffracting element. This may have an advantage of increasing the lifetime of the diffracting element, as it is able to tolerate a larger amount of contaminant deposition while remaining functional.

It may be desirable to be able to amend the propagation direction of diffracted radiation. This may be applicable both for implementations in reflection and/or transmission. In order to achieve this, one or more mirrors may be positioned in the path of the diffracted radiation. The mirror(s) may reflect the diffracted radiation into a direction different from the original direction. This may for example be advantageous if the direction(s) of diffracted radiation are towards a position where it would not be suitable to place a detector.

The assemblies described herein may be provided in a setup using radiation, such as a metrology or inspection apparatus. An apparatus comprising one or more assemblies as described herein may comprise one or more processors for controlling the assembly (e.g. controlling and receiving data from the detector(s), controlling radiation, etc).

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. An assembly for calibrating a radiation wavelength, the assembly comprising:
   an input configured to receive radiation;
   a diffracting element for diffracting radiation, comprising:
      a bottom layer having a lateral periodic structure for diffracting radiation at an upper surface of the bottom layer; and
      a top layer having a lower surface that is adjacent to the periodic structure;
      and wherein the top layer has an upper surface that is flat;
      wherein the diffracting element is arranged to receive the radiation on the upper surface of the top layer, and to reflectively diffract the radiation such that the radiation exits the diffracting element via the upper surface of the top layer; and
   a detector configured to detect the diffracted radiation.
2. An assembly according to clause 1, wherein the top layer has a height extending beyond a height of the lateral periodic structure.
3. An assembly according to clause 1, wherein the top layer has a height that is in line with a height of the lateral periodic structure.
4. An assembly according to any of the preceding clauses, wherein the detector contains a spatially resolved sensor.
5. An assembly according to any of the preceding clauses, wherein the radiation comprises a plurality of wavelengths in a range from 1 nm to 20 nm, in a range from 1 nm to 10 nm, in a range from 10 nm to 20 nm, in a range from 9 nm to 18 nm.
6. An assembly according to any of the preceding clauses, wherein the periodic structure comprises a periodic grating.
7. An assembly according to any of the preceding clauses, wherein the bottom layer comprises a first material and the top layer comprises a second material, wherein optionally the first material and the second material have a different refractive index for the wavelengths of the radiation.
8. An assembly according to clause 7, wherein the second material comprises at least one of an oxide, or a nitride, or a carbon-based material.
9. An assembly according to any of the preceding clauses, wherein the periodic structure has a height difference in a direction perpendicular to the flat surface of the top layer in a range of 1 nm to 10 nm, or in a range of 1 nm to 7.5 nm.
10. An assembly according to any of the preceding clauses, wherein the top layer has a thickness of at least 1 nm, or of at least 2 nm.
11. An assembly according to any of the preceding clauses, wherein the periodic structure has a pitch in a range from 1 nm to 100 nm.
12. An assembly according to any of the preceding clauses, wherein two or more different periodic structures are combined in the diffractive element.
13. An assembly according to any of the preceding clauses, wherein the diffracting element is provided on a substrate support.
14. An assembly according to any of clauses 1 - 12, wherein the diffracting element is provided on a component of an illumination system.
15. An assembly according to clause 12, wherein the component of the illumination system is a toroidal mirror.
16. A metrology apparatus comprising an assembly according to any of clauses 1 - 15.
17. An inspection tool comprising an assembly according to any of clauses 1-15.
18. A lithographic apparatus comprising an assembly according to any of clauses 1 - 15.
19. A litho cell comprising an apparatus according to any of clauses 16 - 18.
20. A reflective mirror comprising an assembly according to any of clauses 1 - 14.
21. A reflective mirror according to clause 20, wherein the reflective mirror comprises a curved reflective surface.
22. A reflective mirror according to clause 21, wherein the reflective mirror is a toroidal mirror.

Although specific reference may be made in this text to the use of lithographic apparatus in the manufacture of Ics, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. An assembly for calibrating a radiation wavelength, the assembly comprising:
an input configured to receive a radiation;
a diffracting element for diffracting the radiation, comprising:
a bottom layer having a lateral periodic structure for diffracting the radiation at an upper surface of the bottom layer; and
a top layer having a lower surface that is adjacent to the periodic structure;
and wherein the top layer has an upper surface that is flat;
wherein the diffracting element is arranged to receive the radiation on the upper surface of the top layer, and to reflectively diffract the radiation such that the radiation exits the diffracting element via the upper surface of the top layer; and
a detector configured to detect the diffracted radiation.

2. An assembly according to claim 1, wherein the top layer has a height extending beyond a height of the lateral periodic structure.

3. An assembly according to claim 1, wherein the top layer has a height that is in line with a height of the lateral periodic structure.

4. An assembly according to any of the preceding claims, wherein the detector contains a spatially resolved sensor.

5. An assembly according to any of the preceding claims, wherein the bottom layer comprises a first material and the top layer comprises a second material.

6. An assembly according to claim 5, wherein the first material and the second material have a different refractive index for the wavelengths of the radiation.

7. An assembly according to claim 5 or 6, wherein the second material comprises at least one of an oxide, or a nitride, or a carbon-based material.

8. An assembly according to any of the preceding claims, wherein the periodic structure has a height difference in a direction perpendicular to the flat surface of the top layer in a range of 1 nm to 10 nm, or in a range of 1 nm to 7.5 nm.

9. An assembly according to any of the preceding claims, wherein the periodic structure has a pitch in a range from 1 nm to 100 nm.

10. An assembly according to any of the preceding claims, wherein two or more different periodic structures are combined in the diffractive element.

11. An assembly according to any of the preceding claims, wherein the diffracting element is provided on a substrate support.

12. An assembly according to any of claims 1 - 10, wherein the diffracting element is provided on a component of an illumination system.

13. An assembly according to claim 12, wherein the component of the illumination system is a toroidal mirror.

14. A metrology or inspection apparatus comprising an assembly according to any of claims 1 - 13.

15. A reflective mirror with a curved reflective surface comprising an assembly according to any of claims 1-12.
